# FASCICULE DE BREVET EUROPEEN

(11) **EP 3 321 936 B1**
(45) Date de publication et mention de la délivrance du brevet: **18.03.2020**
(21) Numéro de dépôt: 17201710.5
(22) Date de dépôt: 14.11.2017
(51) Int. Cl.: G11B 33/12, G06F 1/18

(54) **SUPPORT D'UNITÉ(S) DE SAUVEGARDE DE DONNÉES INFORMATIQUES**
DATENTRÄGER FÜR SPEICHEREINHEIT(EN) VON INFORMATIKDATEN
SUPPORT FOR COMPUTER DATA STORAGE UNIT(S)

(30) Priorité: 15.11.2016 FR 1661055
(43) Date de publication de la demande: 16.05.2018
(73) Titulaire: Freebox, 75008 Paris (FR)
(72) Inventeur: CHARPIOT, Patrick, 92290 CHATENAY MALABRY (FR)
(74) Mandataire: Lavoix

(56) Documents cités:
- US-A1- 2011 005 068
- US-B1- 9 443 558

## Description

La présente invention concerne un support d'unité(s) de sauvegarde de données informatiques configuré pour recevoir au moins deux tailles distinctes d'unité de sauvegarde, le support comprenant un fond et au moins une paroi immobile perpendiculaire au fond.

Par la suite par « unité de sauvegarde de données informatiques », on entend un matériel informatique configuré pour le stockage de données informatiques, tel qu'un seul disque dur ou un ensemble de disques durs DD, ou HD ou encore HDD (respectivement de l'anglais *Hard Disk* ou *Hard Disk Drive*), ou encore un seul disque ou un ensemble de disques comprenant une mémoire flash SSD (de l'anglais *Solid-State Drive*).

Deux tailles standard d'unité de sauvegarde de données informatiques sont actuellement utilisées à savoir 2,5 pouces et 3,5 pouces.

On connait différents types de supports d'unité(s) de sauvegarde de données informatiques propres à recevoir au moins deux tailles distinctes d'unité de sauvegarde.

Un premier type de ces supports est décrit dans le document US 7,515,410 et est basé sur un ensemble de logements de réception identiques d'unités de sauvegarde correspondant à des disques durs. Parmi cet ensemble de logements, certains sont dédiés à recevoir des disques durs de 3,5 pouces tandis que d'autres sont dédiés à recevoir des disques durs de 2,5 pouces et comprennent, pour ce faire, chacun un châssis supplémentaire dans lequel est disposé un disque dur de 2,5 pouces.

Un deuxième type de support est illustré par le document US 2008/0172257, et est basé sur la transformation d'un support dédié à recevoir un disque dur de 3,5 pouces en y ajoutant par vissage un système de tiroirs superposés configurés pour y insérer dans chaque tiroir dédié un disque dur de 2,5 pouces.

Ces deux types de support d'unité(s) de sauvegarde configurés pour recevoir au moins deux tailles distinctes d'unité(s) de sauvegarde requièrent une opération de montage/démontage, l'usage de vis et l'inutilisation de certaines pièces (logement/tiroirs) selon la taille d'unité(s) de sauvegarde de données informatiques reçue(s).

Un troisième type de support est illustré par le document US 9 443 558 B1 pour recevoir au moins deux tailles distinctes d'unité(s) de sauvegarde.

Le but de l'invention est de proposer un autre type de support d'unité(s) de sauvegarde de données informatiques, configuré pour recevoir au moins deux tailles distinctes d'unité de sauvegarde, dont le passage entre deux configurations de réception est plus facile pour l'utilisateur, sans requérir l'usage d'outil, et en évitant que des pièces soient inutilisées dans l'une ou l'autre des configurations de réception.

A cet effet, l'invention a pour objet un support d'unité(s) de sauvegarde de données informatiques selon la revendication 1.

Suivant d'autres aspects avantageux de l'invention, le support d'unité(s) de sauvegarde de données informatiques comprend une ou plusieurs des caractéristiques suivantes, prises isolément ou suivant toutes les configurations techniquement possibles :
- la base s'étend, perpendiculairement à la paroi mobile, et à l'opposé de la paroi immobile par rapport à la paroi mobile ;
- la base, en forme de U, comporte dans sa partie médiane, une encoche de passage d'un rail médian localisé entre les deux rails non adjacents sur lesquels coulisse l'équipage mobile ;
- les rails non adjacents comprennent des profils de guidage dont la longueur est inférieure à la longueur de rail ;
- le fond du support comprend une alternance de rails de matériau constitutif du support et d'ouvertures s'étendant dans la largeur du support, les rails et les ouvertures étant parallèles et obliques par rapport à la perpendiculaire à la paroi immobile;
- le rail médian comprend au moins deux éléments d'encliquetage configurés chacun pour caler la partie médiane du U de la base à l'une desdites au moins deux positions de réception d'unité(s) de sauvegarde associées respectivement aux tailles distinctes d'unité(s) de sauvegarde ;
- la surface de matériau du fond du support est inférieure à la surface des ouvertures du fond du support ;
- l'équipement mobile est amovible du support ;
- la paroi mobile comprend :
   - sur une de ses faces au moins un picot configuré pour bloquer selon la hauteur du support au moins une unité de sauvegarde conforme à une taille, et
   - sur l'autre face au moins un autre picot configuré pour bloquer selon la hauteur du support au moins une unité de sauvegarde conforme à une autre taille ;
- la paroi mobile comprend sur une de ses faces au moins deux picots configurés pour bloquer, en superposition, selon la hauteur du support au moins deux unités de sauvegarde conformes à une même taille ;
- au moins un picot du support est escamotable ou porté par une lame déformable ;
- le support est constitué d'un matériau configuré pour se déformer lors de l'insertion/enlèvement de la ou des unité(s) de sauvegarde ;
- le matériau du support est plastique.

Ces caractéristiques et avantages de l'invention apparaîtront plus clairement à la lecture de la description qui va suivre, donnée uniquement à titre d'exemple non limitatif, et faite en référence aux dessins annexés, sur lesquels :
- les figures 1 et 2 sont des vues en perspective, sous deux angles distincts, de deux configurations de réception d'un même support d'unité(s) de sauvegarde selon l'invention associées à deux tailles distinctes d'unité de stockage;
- la figure 3 est une vue de dessous d'un tel support d'unité(s) de sauvegarde,
- les figures 4 et 5 sont des vues en perspective, sous deux angles distincts de la pièce portant la paroi mobile,
- les figures 6 et 7 sont respectivement des vues en perspective, sous deux angles distincts, des deux configurations de réception du support illustrées sur les figures 1 et 2, avec unité(s) de sauvegarde.
- la figure 8 est une vue en perspective de l'assemblage d'un connecteur à l'unité de sauvegarde du support de la figure 7,
- la figure 9 est une vue en perspective du connecteur de la figure 8,
- la figure 10 est une vue en coupe de l'assemblage du connecteur aux unités de sauvegarde du support illustré par la figure 6.

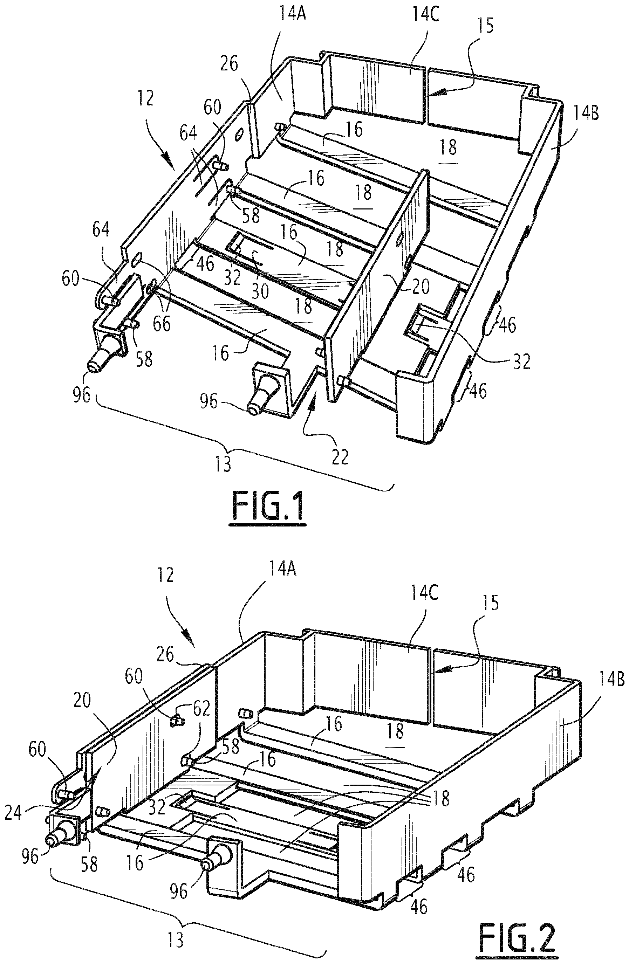

Sur la figure 1, le support 12 d'unité(s) de sauvegarde de données informatiques est rectangulaire. Le support 12 comprend, sur un côté, une ouverture 13 dédiée à la connexion d'unité(s) de sauvegarde. Sur les trois autres côtés, le support 12 est délimité par deux parois longitudinales 14A et 14B et une paroi transversale 14C. Ces trois parois 14A, 14B, 14C immobiles forment ensemble un cadre solidarisé perpendiculairement au fond du support 12.

Pour permettre une déformation manuelle du support 12 selon la largeur, la paroi transversale 14C est munie d'une fente 15.

Le fond du support 12 comprend une alternance de rails parallèles 16 de matériau constitutif du support 12 et d'ouvertures 18 s'étendant dans la largeur du support 12.

Le support 12 comprend également une paroi supplémentaire 20 s'étendant perpendiculairement par rapport au fond du support 12. La paroi 20 est parallèle aux deux parois longitudinales immobiles 14A et 14B du support 12.

Selon l'invention, la paroi supplémentaire 20 est mobile par rapport au fond du support 12. En particulier, la paroi mobile 20 est déplaçable, selon la largeur du support 12, le long d'un rail 16 à coulissement, entre deux positions extrêmes dans laquelle la paroi 20 est appliquée contre l'une ou l'autre des parois longitudinales 14A et 14B.

Sur la figure 1, la paroi mobile 20 est placée, par coulissement sur le fond du support 12 dans une position sortie 22 parallèlement à et entre les deux parois immobiles longitudinales 14A et 14B.

La position sortie 22 de la paroi mobile 20 correspond à une configuration de réception d'une première taille d'unité de sauvegarde de données informatiques par exemple de 2,5 pouces.

Sur la figure 2, la paroi mobile 20 est placée, par coulissement sur le fond du support 12 dans une position escamotée 24 contre la face interne d'une des parois immobiles 14A ou 14B s'étendant selon la longueur du support 12.

La position escamotée 24 de la paroi mobile 20 correspond à une configuration de réception d'une deuxième taille d'unité de sauvegarde de données informatiques, par exemple de 3,5 pouces, supérieure à la première taille associée à la position sortie 22.

La paroi immobile 14A, contre laquelle la paroi mobile 20 est placée est une ligne brisée présentant un décroché 26 configuré pour loger l'épaisseur de la paroi mobile 20 dans la position escamotée 24 telle qu'illustrée sur la figure 2.

Un tel support 12 présente, par exemple, une longueur comprise entre 130 et 200 mm (ou plus selon la profondeur de la baie d'ordinateur ou de serveur dans laquelle le support est destiné à être inséré) et une largeur comprise entre 100 mm et 120 mm. Les parois immobiles 14A, 14B, 14C présentent, par exemple une hauteur comprise entre 25 mm et 50 mm.

La paroi mobile supplémentaire 20 présente une hauteur égale, à plus ou moins 10% près, à la hauteur des parois immobiles 14A, 14B, 14C et une longueur inférieure aux longueurs des parois longitudinales 14A et 14B. La longueur de la paroi mobile 20 est par exemple, comprise entre 70 mm et 100 mm.

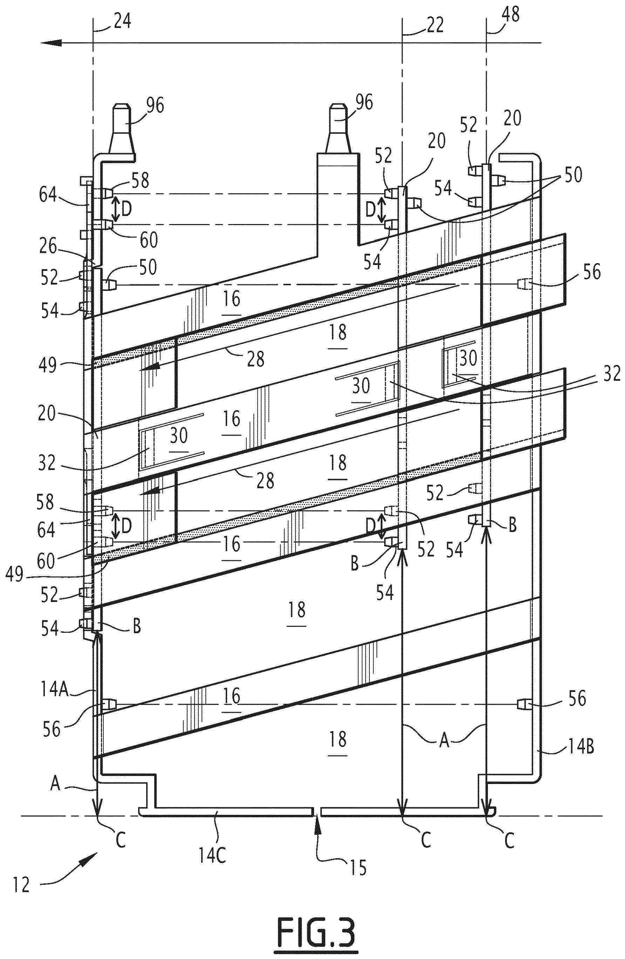

En relation avec la vue de dessous de la figure 3, les rails 16 et les ouvertures 18 sont parallèles et obliques aux parois parallèles immobiles 14A et 14B. En particulier, selon le sens de coulissement 28, où la paroi mobile 20 est propre à être déplacée de la position sortie 22 à la position escamotée 24, la distance A entre :
- l'extrémité B de la paroi mobile 20 la plus proche de la paroi transversale 14C, et
- le point C d'intersection entre la droite passant par la paroi mobile 20 et la droite perpendiculaire passant par la paroi transversale 14C,
   diminue.

Le rail 16 sur lequel la paroi mobile 20 se déplace en coulissement, comprend des éléments d'encliquetage 30 configurés chacun pour caler la paroi mobile 20 à l'une des positions sortie 22 ou escamotée 24.

Un élément d'encliquetage 30 de la paroi mobile 20, est constitué d'une lame élastique crantée, ménagée dans une fente du rail 16, au bout de laquelle est placé un cran d'arrêt 32.

Sur la figure 3, dans la position sortie 22, la largeur de réception comprise entre la paroi immobile 14A du support 12 et la paroi mobile 20, est supérieure de 1 à 2 mm à la largeur d'unité(s) de sauvegarde de données informatiques à placer, ce qui permet une liberté transversale (i.e. un jeu mécanique) de placement.

Pour favoriser la ventilation, la surface de matériau formant les rails 16 du fond du support 12 est inférieure à la surface des ouvertures 18.

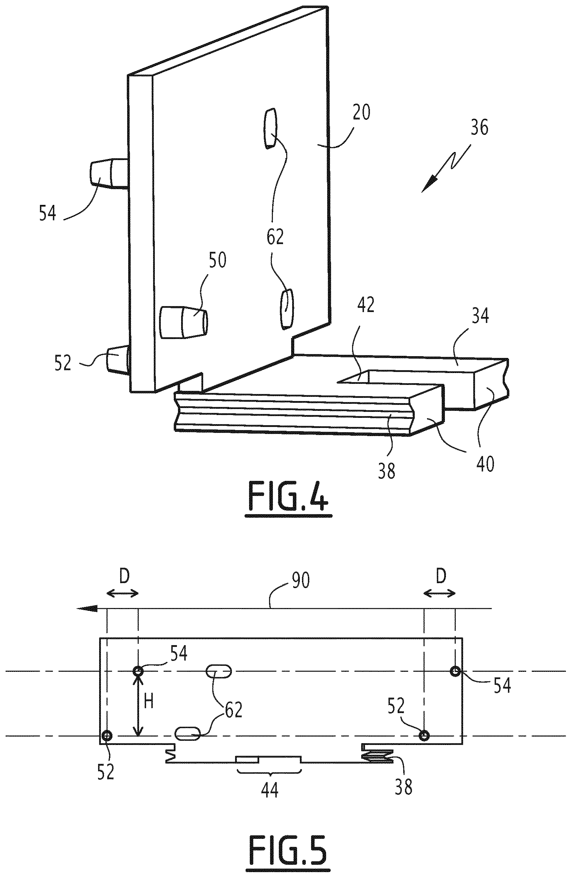

Sur la figure 4, la paroi mobile 20 est portée par une base 34 pour former un équipage mobile 36.

La base 34, en forme de U, s'étend, perpendiculairement à la paroi mobile 20, et à l'opposé de la paroi immobile 14A par rapport à la paroi mobile 20. En d'autres termes, l'équipage mobile 36 est en forme de L.

La base 34 présente deux rainures 38, ouvertes vers l'extérieur des extrémités libres des branches 40 du U, et coopérant avec les bords en regards de deux rails 16 non adjacents.

Dans sa partie médiane 42, la base 34 comporte une encoche inférieure 44 de passage du rail médian 16 présent entre les deux rails 16 sur lesquels coulisse l'équipage mobile 36.

L'équipage mobile 36 est amovible du support 12. La paroi 14B comporte des encoches 46 de passage des extrémités libres des branches 40 de la base 36 lorsque l'équipage mobile 36 est dans la position d'insertion 48 illustrée sur la figure 3.

Au voisinage de la paroi 14B, les rails 16 non adjacents ont des bords en retrait dépourvus de profil de guidage 49 permettant la mise en place de l'équipage mobile 36 entre les rails 16 dans la position d'insertion 48. Autrement dit, la longueur des profils de guidage 49 des rails 16 non adjacents est inférieure à la longueur des rails 16.

Sur la figure 4, la paroi mobile 20 comprend sur la face en regard de la paroi 14B un picot 50 de blocage, selon la hauteur du support 12, d'une unité de sauvegarde lorsque la paroi mobile 20 est dans la position escamotée 24.

Sur la figure 5, sur l'autre face en regard de la paroi 14B, la paroi mobile 20 comprend une ligne de deux picots inférieurs 52 et une ligne de deux picots supérieurs 54 de blocage, selon la hauteur du support 12, d'unités de sauvegarde superposées lorsque la paroi mobile 20 est dans la position sortie 22.

Ces picots inférieurs 52 et ces picots supérieurs 54 permettent d'éviter l'usage traditionnel de vis pour maintenir une unité de sauvegarde sur un support classique.

Sur la figure 3, l'angle aigu formé entre la direction des rails 16 et des ouvertures 18 obliques du support 12 et la perpendiculaire aux deux parois immobiles parallèles 14A et 14B est configuré pour aligner, perpendiculairement aux deux parois longitudinales parallèles 14A et 14B:
- les deux lignes de picots inférieurs 52 et supérieurs 54 de la paroi mobile 20 respectivement avec les deux lignes de picots inférieurs 58 et supérieurs 60 de la paroi 14A lorsque la paroi mobile 20 est dans la position de sortie 22, et
- le picot 50 de la paroi mobile 20 avec un picot 56 correspondant de la paroi 14B lorsque la paroi mobile 20 est dans la position escamotée 24.

Les picots 50, 52, 54, 56, 58, 60 sont propres à supporter, tels des taquets, la face inférieure d'une unité de sauvegarde, ou à être insérés, tel des goujons, transversalement dans des orifices (i.e. trous taraudés) dédiés placés sur les faces latérales et longitudinales des unités de sauvegarde de données informatiques.

Par ailleurs, la paroi mobile 20 comprend des lumières 62 pour le passage des picots 58 et 60 de la paroi 14A lorsque la paroi mobile 20 est dans la position escamotée 24. Réciproquement, la paroi immobile 14A comprend des lumières 66 pour le passage des picots 54 et 52 de la paroi mobile 20 en position escamotée 24.

Au moins un des picots 58, 60 de la paroi 14A, est escamotable ou porté par une lame déformable 64 intégrée à la paroi 14A.

Le support 12 est constitué d'un matériau, par exemple plastique, configuré pour se déformer en insérant/enlevant la ou les unité(s) de sauvegarde de données informatiques.

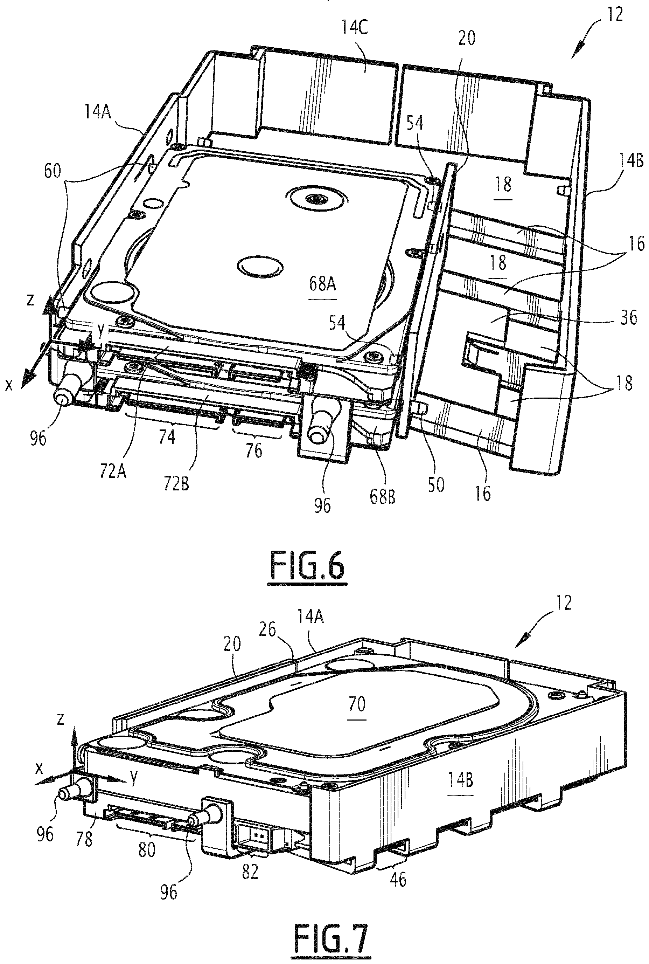

Sur la figure 6 deux unités 68A et 68B de sauvegarde de données de 2,5 pouces sont insérées en superposition dans le support 12 où la paroi mobile 20 est dans la position sortie 22.

Les deux unités 68A et 68B de sauvegarde de données de 2,5 pouces comprennent respectivement deux connecteurs mâles 72A et 72B dans l'ouverture 13 du support 12 illustrée sur les figures 1 et 2. Chaque connecteur mâle 72A ou 72B comprend au moins une ligne 74 de picots d'alimentation électrique et au moins une ligne 76 de picots de communication de données.

Sur la figure 7 une unité 70 de sauvegarde de données de 3,5 pouces est insérée dans le support 12 où la paroi mobile 20 est dans la position escamotée 24.

L'unité 70 de sauvegarde de données de 3,5 pouces comprend un connecteur mâle 78 dans l'ouverture 13 du support 12. Le connecteur mâle 78 comprend également au moins une ligne 80 de picots d'alimentation électrique et au moins une ligne 82 de picots de communication de données.

On constate que dans le repère (x, y, z) centré sur l'extrémité libre de la paroi 14B, la position du connecteur mâle inférieur 72B dans la position sortie 22 de la paroi mobile 20 et la position du connecteur mâle 78 dans la position escamotée 24 de la paroi mobile 20 sont identiques.

Autrement dit, la paroi mobile 20 est un élément de positionnement d'unité(s) de sauvegarde de données informatiques permettant, selon sa position, sortie 22 ou escamotée 24, de conserver une position de connexion permanente et indépendante de la taille d'unité(s) de sauvegarde de données informatiques.

Par ailleurs, il existe une dépendance entre la longueur des picots 58 et 60 de la paroi 14B, la longueur du picot 50 de la paroi mobile 20 et l'épaisseur de la paroi mobile 20.

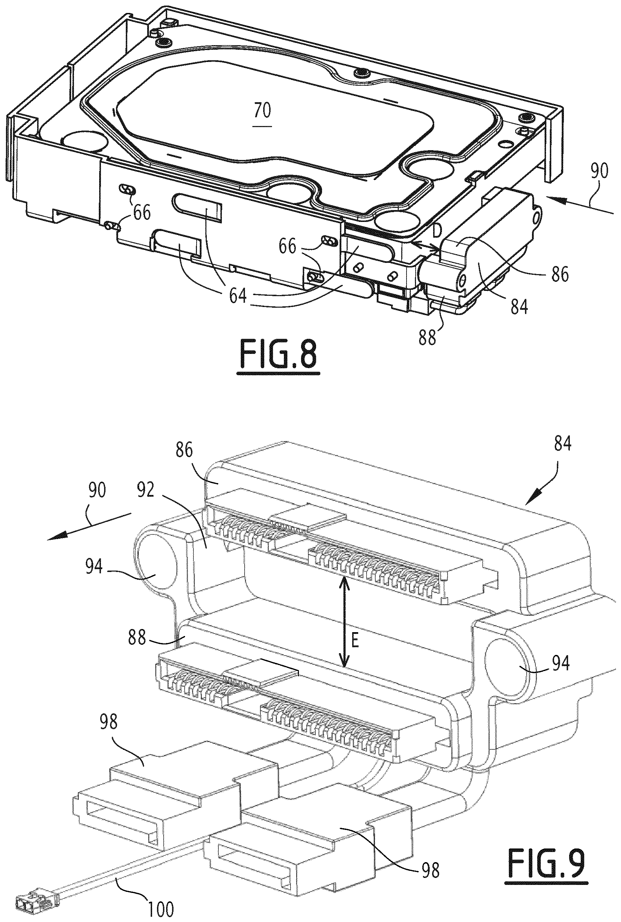

Sur la figure 8 un connecteur femelle 84 est assemblé au connecteur mâle 78 de l'unité de sauvegarde de données informatiques 70 du support 12 de la figure 7. Le connecteur femelle 84 est multi-étages et comprend deux étages 86 et 88 de connexion superposés et solidarisés l'un à l'autre, tels que représentés sur la figure 9. Un tel connecteur multi-étages 84 est par exemple solidarisé en fond de baie d'ordinateur ou de serveur.

Sur la figure 9, l'étage de connexion supérieur 86 du connecteur multi-étages 84 est décalé par rapport à l'étage 88 de connexion inférieur, selon un décalage D non nul, vers l'arrière par rapport au sens 90 de connexion du connecteur multi-étages 84 au(x) connecteur(s) 78 ou 72A et 72B d'unité(s) de sauvegarde de données informatiques portée(s) par le support 12.

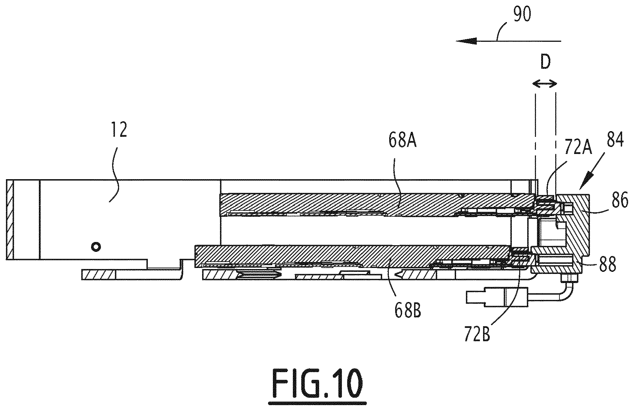

Réciproquement, sur la figure 10, le connecteur mâle supérieur 72A est décalé rapport au connecteur mâle inférieur 72B, selon le même décalage D non nul, vers l'arrière par rapport au sens 90 de connexion.

Les éléments de décalage du support 12 permettant un tel décalage D non nul selon le sens 90 de connexion des connecteurs mâles 72A et 72B d'unités 68A et 68B de sauvegarde superposées, sont d'une part les deux lignes de picots inférieurs 52 et supérieurs 54 portés par la paroi mobile 20 représentés sur les figures 3 et 5, et d'autre part les deux lignes de picots inférieurs 58 et supérieurs 60 portés la paroi 14B représentés sur la figure 3.

En d'autres termes, la position des picots inférieurs 52, 58 et supérieurs 54, 60 de décalage du support 12 est complémentaire, selon le sens 90 de connexion, de celle des étages de connexion inférieur 88, et supérieur 86 du connecteur multi-étages 84.

Le connecteur multi-étages 84 est formé d'une seule pièce, par exemple par surmoulage.

Par ailleurs, les au moins deux étages de connexion 86 et 88 sont espacés par un étage 92 d'espacement, selon la hauteur du connecteur multi-étages 84.

Pour favoriser la ventilation et permettre la réception de différentes épaisseurs d'unité(s) de sauvegarde de données informatiques, les deux lignes de picots inférieurs 52 et supérieurs 54 de la paroi mobile 20, et les deux lignes correspondantes de picots inférieurs 58 et supérieurs 60 de la paroi 14B sont espacées selon la hauteur d'une distance H supérieure à une épaisseur maximale d'unité(s) de sauvegarde de données informatiques.

Réciproquement, la hauteur E de l'étage 92 d'espacement du connecteur multi-étages 84 dépend de la distance H entre les lignes de picots du support 12.

Par ailleurs, l'étage 92 d'espacement du connecteur multi-étages 84 comprend au moins une ouverture 94 destinée à coopérer, selon le sens 90 de connexion avec un élément de guidage de connexion 96 du support 12.

Le connecteur multi-étages 84 comprend en outre au moins deux ports 98 SATA (de l'anglais *Serial Advanced Technology Attachment*) associés respectivement aux au moins deux étages 86 et 88 de connexion et relié à la carte mère d'ordinateur ou de serveur non représentée. Le connecteur multi-étages 84 comprend également un port 100 d'alimentation électrique.

On conçoit qu'avec un tel support 12 pour unité(s) de sauvegarde de données informatiques, le changement de taille d'unité(s) de sauvegarde est manuel, simple et rapide.

De plus, ce changement ne nécessite aucun outil ni pièce supplémentaire et aucune partie du support 12 ou du connecteur multi-étages 84 n'entrave la bonne installation d'une unité de sauvegarde de données informatiques dans la configuration de réception sélectionnée par l'utilisateur.

## Revendications

1. Support (12) d'unité(s) (68A, 68B, 70) de sauvegarde de données informatiques, configuré pour recevoir au moins deux tailles distinctes d'unité(s) (68A, 68B, 70) de sauvegarde, le support (12) comprenant un fond et au moins une paroi immobile (14A) perpendiculaire au fond,
et comprend en outre une paroi supplémentaire (20) s'étendant perpendiculairement par rapport au fond du support (12) et parallèlement par rapport à la paroi immobile (14A), la paroi supplémentaire (20) étant montée mobile selon la largeur du support, par rapport au fond du support (12), entre au moins deux positions (22, 24) de réception associées respectivement à des largeurs de réception distinctes d'unité(s) (68A, 68B, 70) de sauvegarde,
**caractérisé en ce que** la paroi mobile (20) est portée par une base (34) pour former un équipage mobile (36) coulissant dans au moins un rail (16) du fond du support (12), la base (34) étant en forme de U et présentant deux rainures (38), ouvertes vers l'extérieur des extrémités libres des branches (40) du U, et coopérant avec les bords en regards de deux rails (16) non adjacents du fond du support (12).

2. Support (12) d'unité(s) (68A, 68B, 70) de sauvegarde de données informatiques selon la revendication 1, dans lequel la base (34) s'étend, perpendiculairement à la paroi mobile (20), et à l'opposé de la paroi immobile (14A) par rapport à la paroi mobile (20).

3. Support (12) d'unité(s) (68A, 68B, 70) de sauvegarde de données informatiques selon la revendication 1 ou 2, dans lequel la base (34), en forme de U, comporte dans sa partie médiane (42), une encoche (44) de passage d'un rail médian (16) localisé entre les deux rails (16) non adjacents sur lesquels coulisse l'équipage mobile (36).

4. Support (12) d'unité(s) (68A, 68B, 70) de sauvegarde de données informatiques selon la revendication 3, dans lequel les rails (16) non adjacents comprennent des profils de guidage (49) dont la longueur est inférieure à la longueur de rail.

5. Support (12) d'unité(s) (68A, 68B, 70) de sauvegarde de données informatiques selon l'une quelconque des revendications 1 à 3, dans lequel le fond du support (12) comprend une alternance de rails (16) de matériau constitutif du support (12) et d'ouvertures (18) s'étendant dans la largeur du support (12), les rails (16) et les ouvertures étant parallèles et obliques par rapport à la perpendiculaire à la paroi immobile (14A).

6. Support (12) d'unité(s) (68A, 68B, 70) de sauvegarde de données informatiques selon la revendication 3 ou 4, dans lequel le rail médian (16) comprend au moins deux éléments d'encliquetage (30) configurés chacun pour caler la partie médiane (42) du U de la base (34) à l'une desdites au moins deux positions (22, 24) de réception d'unité(s) de sauvegarde associées respectivement aux tailles distinctes d'unité(s) de sauvegarde.

7. Support (12) d'unité(s) (68A, 68B, 70) de sauvegarde de données informatiques selon la revendication 5 ou 6, dans lequel la surface de matériau du fond du support est inférieure à la surface des ouvertures (18) du fond du support (12).

8. Support (12) d'unité(s) (68A, 68B, 70) de sauvegarde de données informatiques selon l'une quelconque des revendications précédentes, dans lequel l'équipement mobile (36) est amovible du support (12).

9. Support (12) d'unité(s) (68A, 68B, 70) de sauvegarde de données informatiques selon l'une quelconque des revendications précédentes, dans laquelle la paroi mobile (20) comprend :
- sur une de ses faces au moins un picot (50) configuré pour bloquer selon la hauteur du support au moins une unité de sauvegarde conforme à une taille, et
- sur l'autre face au moins un autre picot (52) configuré pour bloquer selon la hauteur du support au moins une unité de sauvegarde conforme à une autre taille.

10. Support (12) d'unité(s) (68A, 68B, 70) de sauvegarde de données informatiques selon l'une quelconque des revendications précédentes, dans laquelle la paroi mobile (20) comprend sur une de ses faces au moins deux picots (52, 54) configurés pour bloquer, en superposition, selon la hauteur du support au moins deux unités de sauvegarde conformes à une même taille.

11. Support (12) d'unité(s) (68A, 68B, 70) de sauvegarde de données informatiques selon l'une quelconque des revendications précédentes, dans lequel au moins un picot (58, 60) du support (12) est escamotable ou porté par une lame déformable (64).

12. Support (12) d'unité(s) (68A, 68B, 70) de sauvegarde de données informatiques selon l'une quelconque des revendications précédentes dans lequel le support (10) est constitué d'un matériau configuré pour se déformer lors de l'insertion/enlèvement de la ou des unité(s) de sauvegarde (68A, 68B, 70).

13. Support d'unité(s) de sauvegarde de données informatiques selon la revendication 12, dans lequel le matériau est plastique.

## Patentansprüche

1. Halterung (12) für Datenspeichereinheit(en) (66A, 66B, 70), die ausgebildet ist, mindestens zwei unterschiedliche Größen von Datenspeichereinheit(en) (66A, 66B, 70) aufzunehmen, wobei die Halterung (12) einen Boden und mindestens eine feststehende Wand (14A) senkrecht zum Boden umfasst,
und außerdem eine zusätzliche Wand (20) umfasst, die sich in Bezug auf den Boden der Halterung (12) senkrecht und in Bezug auf die feststehende Wand (14A) parallel erstreckt, wobei die zusätzliche Wand (20) gemäß der Breite der Halterung in Bezug auf den Boden der Halterung (12) zwischen mindestens zwei Aufnahmepositionen (22, 24) beweglich ist, die jeweils unterschiedlichen Aufnahmebreiten der Speichereinheit(en) (68A, 68B, 70) zugeordnet sind,
**dadurch gekennzeichnet, dass** die bewegliche Wand (20) von einer Basis (34) getragen ist, um eine bewegliches Element (36) zu bilden, das in mindestens einer Schiene (16) des Bodens der Halterung (12) gleitet, wobei die Basis (34) in einer U-Form ausgebildet ist und zwei Nuten (38) aufweist, die an den freien Enden der Schenkel (40) des U nach außen offen sind und die mit den gegenüberstehenden Rändern von zwei nicht benachbarten Schienen (16) des Bodens der Halterung (12) zusammenarbeiten.

2. Halterung (12) für Datenspeichereinheit(en) (66A, 66B, 70) nach Anspruch 1, bei der die Basis (34) sich senkrecht zu der beweglichen Wand (20) und entgegengesetzt zur feststehenden Wand (14A) in Bezug auf die bewegliche Wand (20) erstreckt.

3. Halterung (12) für Datenspeichereinheit(en) (66A, 66B, 70) nach Anspruch 1 oder 2, bei denen die Basis (34) im U-Form in ihrem Mittelteil (42) eine Ausnehmung (44) für den Durchgang einer mittleren Schiene (16) aufweist, die zwischen den zwei nicht benachbarten Schienen (16), auf denen das bewegliche Element (36) gleitet, liegt.

4. Halterung (12) für Datenspeichereinheit(en) (66A, 66B, 70) nach Anspruch 3, bei der die nicht benachbarten Schienen (16) Führungsprofile (49) umfassend, deren Länge kleiner als die Länge der Schiene ist.

5. Halterung (12) für Datenspeichereinheit(en) (66A, 66B, 70) nach einem beliebigen der Ansprüche 1 bis 3, bei der der Boden der Halterung (12) abwechselnd Schienen (16) aus Bestandsmaterial der Halterung (12) und Öffnungen (18) umfasst, die sich in der Breite der Halterung (12) erstrecken, wobei die Schienen (16) und die Öffnungen parallel und schräg in Bezug auf die Senkrechte zur feststehenden Wand (14A) sind.

6. Halterung (12) für Datenspeichereinheit(en) (66A, 66B, 70) nach Anspruch 3 oder 4, bei der die mittlere Schiene (16) mindestens zwei Rastelemente (30) umfasst, die jeweils ausgebildet sind, den mittleren Teil (42) des U der Basis (34) in einer der mindestens zwei Positionen (22, 24) zur Aufnahme der Datenspeichereinheit(en), die jeweils den unterschiedlichen Größen der Datenspeichereinheit(en) zugeordnet sind, zu stützen.

7. Halterung (12) für Datenspeichereinheit(en) (66A, 66B, 70) nach Anspruch 5 oder 6, bei der die Materialfläche des Bodens der Halterung kleiner ist als die Fläche der Öffnungen (18) des Bodens der Halterung (12).

8. Halterung (12) für Datenspeichereinheit(en) (66A, 66B, 70) nach einem beliebigen der vorhergehenden Ansprüche, bei der das bewegliche Element (36) von der Halterung (12) entfernbar ist.

9. Halterung (12) für Datenspeichereinheit(en) (66A, 66B, 70) nach einem beliebigen der vorhergehenden Ansprüche, bei der die bewegliche Wand (20) umfasst:
- an einer ihrer Flächen mindestens einen Zapfen (50), der ausgebildet ist, hinsichtlich der Höhe der Halterung mindestens eine Datenspeichereinheit entsprechend einer Größe zu blockieren, und
- an der anderen Fläche mindestens einen anderen Zapfen (52) der ausgebildet ist, hinsichtlich der Höhe der Halterung mindestens eine Datenspeichereinheit entsprechend einer anderen Größe zu blockieren.

10. Halterung (12) für Datenspeichereinheit(en) (66A, 66B, 70) nach einem beliebigen der vorhergehenden Ansprüche, bei der die bewegliche Wand (20) an einer ihrer Flächen mindestens zwei Zapfen (52, 54) umfasst, die ausgebildet sind, in Übereinanderlage mindestens zwei Datenspeichereinheiten entsprechend einer selben Größe hinsichtlich der Höhe der Halterung zu blockieren.

11. Halterung (12) für Datenspeichereinheit(en) (66A, 66B, 70) nach einem beliebigen der vorhergehenden Ansprüche, bei der mindestens ein Zapfen (58, 60) der Halterung (12) versenkbar ist oder von einer deformierbaren Schneide (64) getragen wird.

12. Halterung (12) für Datenspeichereinheit(en) (66A, 66B, 70) nach einem beliebigen der vorhergehenden Ansprüche, bei der die Halterung (12) aus einem Material besteht, das ausgebildet ist, sich bei dem Einsetzen/Herausnehmen der Datenspeichereinheit(en) (66A, 66B, 70) zu verformen.

13. Halterung (12) für Datenspeichereinheit(en) (66A, 66B, 70) nach Anspruch 12, bei der das Material Kunststoff ist.

## Claims

1. Computer data back-up unit (68A, 68B, 70) support (12) designed to receive at least two distinct sizes of back-up units (68A, 68B, 70), wherein the support (12) comprises a bottom and at least one stationary wall (14A) perpendicular to the bottom,
and further comprises an additional wall (20) extending perpendicularly to the bottom of the support (12) and parallel to the stationary wall (14A), wherein the additional wall is mounted to be movable in the direction of the width of the support relative to the bottom of the support (12) between at least two receiving slots (22, 24) that are respectively associated with distinct receiving widths of the back-up units (68A, 68B, 70),
**characterized in that** the movable wall (20) is supported on a base (34) to form a movable assembly (36) sliding in at least one rail (16) of the bottom of the support (12), the base (34) being U-shaped and having two grooves (38) that are open towards the outside of the free ends of the arms (40) of the U, and that interact with the facing edges of two non-adjacent rails (16) of the bottom of the support (12).

2. Computer data back-up unit (68A, 68B, 70) support (12) according to claim 1, wherein the base (34) extends perpendicularly to the movable wall (20), and away from the stationary wall (14A) with respect to the movable wall (20).

3. Computer data back-up unit (68A, 68B, 70) support (12) according to claim 1 or 2, wherein the U-shaped base (34) comprises a notch (44) in its central part (42) for the passage of a central rail (16) situated between the two non-adjacent rails (16) on which the mobile assembly (36) slides.

4. Computer data back-up unit (68A, 68B, 70) support (12) according to claim 3, wherein the non-adjacent rails (16) comprise guide profiles (49) whose length is shorter than the rail length.

5. Computer data back-up unit (68A, 68B, 70) support (12) according to one of the claims 1 to 3, wherein the bottom of the support (12) comprises an alternating arrangement of rails (16) of material constituting the support (12) and openings (18) extending in the direction of the width of the support (12), wherein the rails (16) and the openings are parallel and inclined to the perpendicular to the stationary wall (14A).

6. Computer data back-up unit (68A, 68B, 70) support (12) according to claim 3 or 4, wherein the center rail (16) comprises at least two latching elements (30) each designed to wedge the central portion (42) of the U of the base (34) to one of the at least two back-up units receiving slots (22, 24) respectively associated with the distinct sizes of the units.

7. Computer data back-up unit (68A, 68B, 70) support (12) according to claim 5 or 6, wherein the material surface of the bottom of the support is smaller than the surface of the openings (18) of the bottom of the support (12).

8. Computer data back-up unit (68A, 68B, 70) support (12) according to any one preceding claims, wherein the mobile assembly (36) is detachable from the support (12).

9. Computer data back-up unit (68A, 68B, 70) support (12) according to any one of the preceding claims, wherein the movable wall (20) comprises:
- at least one pin (50) on one of its faces that is configured to block, along the height of the support, at least one back-up unit according to one size, and
- at least one other pin (52) on the other face that is configured to block, along the height of the support, at least one back-up unit according to one other size.

10. Computer data back-up unit (68A, 68B, 70) support (12) according to any one of the preceding claims, wherein the movable wall (20) comprises, on one of its faces, at least two pins (52, 54) designed to block, in superposition, along the height of the support, at least two back-up units of the same size.

11. Computer data back-up unit (68A, 68B, 70) support (12) according to any one of the preceding claims, wherein at least one pin (58, 60) of the support (12) is retractable or supported by a deformable strip (64).

12. Computer data back-up unit (68A, 68B, 70) support (12) according to any one of the preceding claims, wherein the support (10) is made of a material configured to deform during the insertion/removal of the back-up unit(s) (68A, 68B, 70).

13. A computer data back-up unit support according to claim 12, wherein the material is plastic.
